(19) Europäisches Patentamt
European Patent Office
Office européen des brevets

(11) **EP 2 805 991 A1**

## (12) EUROPEAN PATENT APPLICATION

(43) Date of publication:
**26.11.2014 Bulletin 2014/48**

(51) Int Cl.:
**C08J 9/00** (2006.01)  **C08J 9/10** (2006.01)
**F16F 15/00** (2006.01)  **F16F 1/36** (2006.01)

(21) Application number: **14159322.8**

(22) Date of filing: **13.03.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **19.03.2013 JP 2013057147**

(71) Applicant: **NITTO DENKO CORPORATION**
**Ibaraki-shi,**
**Osaka 567-8680 (JP)**

(72) Inventors:
• **Iwase, Takayuki**
**Osaka, 567-8680 (JP)**
• **Hirai, Bunta**
**Osaka, 567-8680 (JP)**
• **Matsuda, Eiji**
**Osaka, 567-8680 (JP)**

(74) Representative: **Schwabe - Sandmair - Marx**
**Patentanwälte**
**Stuntzstraße 16**
**81677 München (DE)**

(54) **Vibration-proof material, vibration-proof structure, and vibration-proof method**

(57)     A vibration-proof material is obtained by foaming a rubber composition containing an ethylene-propylene-diene rubber. The content ratio of a sulfur atom calculated based on the measurement result of a fluorescent X-ray measurement, based on mass, is 1000 ppm or less and the vibration-proof material has a Young's modulus at 23°C of $6.0 \times 10^5$ Pa or less.

Fig. 1

EP 2 805 991 A1

**Description**

BACKGROUND OF THE INVENTION

Field of the Invention

The present invention relates to a vibration-proof material, a vibration-proof structure, and a vibration-proof method, to be specific, to a vibration-proof material, a vibration-proof structure including the vibration-proof material, and a vibration-proof method using the vibration-proof material.

Description of Related Art

A vibration-proof material for reducing a vibration of a vibrating object has been conventionally used for various industrial products.

For example, in a hard disk drive (HDD) to be mounted on an electrical and electronic device such as a personal computer, when a vibration or impact is applied thereto at the time of writing or reading, an error occurs or a defect causing a noise occurs. Thus, a vibration-proof material is disposed between an HDD main body and a wired circuit board that processes reading or writing thereof.

As such a vibration-proof material, a foamed material obtained by foaming an ethylene-propylene-diene rubber (hereinafter, may be abbreviated as an EPDM) has been known (ref: for example, Japanese Unexamined Patent Publication No. 2000-65134).

SUMMARY OF THE INVENTION

The vibration-proof material described in Japanese Unexamined Patent Publication No. 2000-65134 is produced by foaming an EPDM with a foaming agent and cross-linking the EPDM with sulfur.

When the EPDM is cross-linked with the sulfur, however, there is a disadvantage that a metal (silver or the like, in particular) contained in a vibration-proof object is corroded by the sulfur that remains in an EPDM foamed material. In an electrical and electronic device such as an HDD, in particular, there may be a case where the accuracy of the device is reduced even by slight corrosion, so that rigid corrosion resistance is required.

Also, the further improvement of the vibration resistance is desired with the progress in miniaturization of hard disk drives.

It is an object of the present invention to provide a vibration-proof material that reduces corrosive properties with respect to a vibration-proof object and has excellent vibration resistance, a vibration-proof structure including the vibration-proof material, and a vibration-proof method using the vibration-proof material.

A vibration-proof material of the present invention is obtained by foaming a rubber composition containing an ethylene-propylene-diene rubber, wherein the content ratio of a sulfur atom calculated based on the measurement result of a fluorescent X-ray measurement, based on mass, is 1000 ppm or less and the vibration-proof material has a Young's modulus at 23°C of $6.0 \times 10^5$ Pa or less.

In the vibration-proof material of the present invention, it is preferable that the content ratio of sulfur $S_8$ calculated based on the measurement result of a gel permeation chromatography, based on mass, is 100 ppm or less.

In the vibration-proof material of the present invention, it is preferable that the vibration-proof material has an apparent density of 0.20 g/cm$^3$ or less.

In the vibration-proof material of the present invention, it is preferable that the rubber composition contains a derivative of p-quinonedioxime and a polyol.

In the vibration-proof material of the present invention, it is preferable that the polyol is a polyethylene glycol.

In the vibration-proof material of the present invention, it is preferable that the rubber composition further contains an organic peroxide.

In the vibration-proof material of the present invention, it is preferable that the ethylene-propylene-diene rubber has long chain branching.

A vibration-proof structure of the present invention includes the above-described vibration-proof material and a wired circuit board provided at a surface of the vibration-proof material.

A vibration-proof method of the present invention includes the steps of preparing the above-described vibration-proof material and providing the vibration-proof material in a wired circuit board.

The vibration-proof material of the present invention is obtained by foaming a rubber composition containing an ethylene-propylene-diene rubber. In the vibration-proof material, the content proportion of a sulfur atom measured by a fluorescent X-ray analysis method is not more than a specific value, so that the corrosive properties are reduced and the Young's modulus is not more than a specific value, so that the vibration resistance is excellent.

Thus, when the vibration-proof material is used, corrosion of a vibration-proof object is suppressed and the vibration of the vibration-proof object is capable of being sufficiently reduced.

According to the vibration-proof structure and the vibration-proof method of the present invention, the above-described vibration-proof material is used, so that corrosion of a wired circuit board is suppressed and the vibration of the wired circuit board is capable of being surely reduced.

BRIEF DESCRIPTION OF THE DRAWINGS

FIG 1 shows a side sectional view for illustrating one embodiment of an electrical and electronic device including a vibration-proof structure of the present invention.

FIG 2 shows a schematic view for illustrating a measurement device used for the measurement of the Young's modulus and the evaluation of the vibration resistance.

DETAILED DESCRIPTION OF THE INVENTION

A vibration-proof material of the present invention is obtained by foaming a rubber composition containing an EPDM. That is, the vibration-proof material is obtained as an EPDM foamed material.

The EPDM is a rubber obtained by copolymerization of ethylene, propylene, and dienes. The further copolymerization of the dienes, in addition to the ethylene and the propylene, allows introduction of an unsaturated bond and enables cross-linking with a cross-linking agent to be described later.

Examples of the dienes include 5-ethylidene-2-norbornene, 1,4-hexadiene, and dicyclopentadiene. These dienes can be used alone or in combination of two or more.

A content of the dienes (a diene content) in the EPDM is, for example, 1 mass % or more, preferably 2 mass % or more, or more preferably 3 mass % or more, and is, for example, 20 mass % or less, or preferably 15 mass % or less.

When the content of the dienes is not less than the above-described lower limit, surface shrinkage of the vibration-proof material is capable of being reduced. When the content of the dienes is not more than the above-described upper limit, the occurrence of a crack in the vibration-proof material is capable of being reduced.

A preferable example of the EPDM includes an EPDM having long chain branching.

A method for introducing a long branched chain into the EPDM is not particularly limited and a known method such as polymerization with a metallocene catalyst is used.

The EPDM is, for example, produced with a catalyst such as a Ziegler-Natta catalyst or a metallocene catalyst. Preferably, in view of obtaining a long branched chain, the EPDM is produced with a metallocene catalyst. When the EPDM has long chain branching, the elongational viscosity is increased due to the entanglement of the side chain, so that the rubber composition is capable of being excellently foamed and having flexibility.

The rubber composition preferably contains a cross-linking agent and a foaming agent.

An example of the cross-linking agent includes a cross-linking agent that fails to contain a sulfur atom in a molecule. To be specific, examples thereof include a quinoid compound and an organic peroxide.

The quinoid compound is an organic compound (a quinoid-based cross-linking agent) having a quinoid structure. Examples thereof include p-quinonedioxime, poly-p-dinitrosobenzene, and a derivative thereof. To be specific, an example of the derivative of the p-quinonedioxime includes p,p'-dibenzoylquinonedioxime.

These quinoid compounds can be used alone or in combination of two or more.

As the quinoid compound, preferably, a derivative of p-quinonedioxime is used, or more preferably, p,p'-dibenzoylquinonedioxime is used.

When the derivative of the p-quinonedioxime is used as the quinoid compound, the rubber composition is cross-linked with the derivative of the p-quinonedioxime, so that the content proportion of a sulfur atom is capable of being reduced and in this way, a reduction in the corrosive properties is achieved and excellent foaming properties and excellent vibration resistance are capable of being ensured.

The mixing ratio of the quinoid compound with respect to 100 parts by mass of the EPDM is, for example, 0.05 parts by mass or more, or preferably 0.5 parts by mass or more, and is, for example, 30 parts by mass or less, preferably 20 parts by mass or less, more preferably 10 parts by mass or less, or further more preferably 5 parts by mass or less. Among all, when the derivative of the p-quinonedioxime is used, the mixing ratio thereof with respect to 100 parts by mass of the EPDM is, for example, 0.05 parts by mass or more, preferably 0.5 parts by mass or more, or more preferably 1.0 part by mass or more, and is, for example, 20 parts by mass or less, preferably 10 parts by mass or less, more preferably 5 parts by mass or less, or further more preferably 3 parts by mass or less.

The organic peroxide is an organic compound (an organic peroxide-based cross-linking agent) having a peroxide structure.

To be specific, examples thereof include dicumyl peroxide, dimethyl di(t-butylperoxy)hexane, 1,1-di(t-butylperoxy)cyclohexane, and α,α'-di(t-butylperoxy)diisopropyl benzene.

These organic peroxides can be used alone or in combination of two or more.

The mixing ratio of the organic peroxide with respect to 100 parts by mass of the EPDM is, for example, 0.05 parts by mass or more, preferably 0.5 parts by mass or more, or more preferably 1 part by mass or more, and is, for example, 20 parts by mass or less, preferably 15 parts by mass or less, more preferably 10 parts by mass or less, further more preferably 5 parts by mass or less, or particularly preferably 2 parts by mass or less.

These cross-linking agents can be used alone or in combination of two or more. As the cross-linking agent, preferably, a quinoid compound and an organic peroxide are used in combination.

When the quinoid compound and the organic peroxide are used in combination, the cross-linking on the surface of the vibration-proof material is capable of being sufficiently ensured, so that the occurrence of tackiness on the surface is capable of being reduced.

When the quinoid compound and the organic peroxide are used in combination, in the mixing ratio thereof, the ratio of the organic peroxide with respect to 100 parts by mass of the quinoid compound is, for example, 1 part by mass or more, or preferably 10 parts by mass or more, and is, for example, 500 parts by mass or less, preferably 200 parts by mass or less, more preferably 100 parts by mass or less, or further more preferably 50 parts by mass or less.

Examples of the foaming agent include an organic foaming agent and an inorganic foaming agent.

Examples of the organic foaming agent include an azo foaming agent such as azodicarbonamide (ADCA), barium azodicarboxylate, azobisisobutylonitrile (AIBN), azocyclohexylnitrile, and azodiaminobenzene; an N-Nitroso foaming agent such as N,N'-dinitrosopentamethylenetetramine (DTP), N,N'-dimethyl-N,N'-dinitrosoterephthalamide, and trinitrosotrimethyltriamine; a hydrazide foaming agent such as 4,4'-oxybis(benzenesulfonylhydrazide) (OBSH), paratoluenesulfonylhydrazide, diphenylsulfone-3,3'-disulfonylhydrazide, 2,4-toluenedisulfonylhydrazide, p,p-bis(benzenesulfonylhydrazide)ether, benzene-1,3-disulfonylhydrazide, and allylbis(sulfonylhydrazide); a semicarbazide foaming agent such as p-toluylenesulfonylsemicarbazide and 4,4'-oxybis(benzenesulfonylsemicarbazide); a fluorinated alkane foaming agent such as trichloromonofluoromethane and dichloromonofluoromethane; a triazole-based foaming agent such as 5-morpholyl-1,2,3,4-thiatriazole; and other known organic foaming agents. Also, an example of the organic foaming agent includes thermally expansive microparticles in which a heat-expandable substance is encapsulated in a microcapsule. An example of the thermally expansive microparticles can include a commercially available product such as Microsphere (trade name, manufactured by Matsumoto Yushi-Seiyaku Co., Ltd.).

Examples of the inorganic foaming agent include hydrogencarbonate such as sodium hydrogen carbonate and ammonium hydrogen carbonate; carbonate such as sodium carbonate and ammonium carbonate; nitrite such as sodium nitrite and ammonium nitrite; borohydride salt such as sodium borohydride; azides; and other known inorganic foaming agents.

As the foaming agent, preferably, an organic foaming agent is used, or further more preferably, an azo foaming agent is used.

These foaming agents can be used alone or in combination of two or more.

The mixing ratio of the foaming agent with respect to 100 parts by mass of the EPDM is, for example, 0.1 parts by mass or more, preferably 1 part by mass or more, or more preferably 10 parts by mass or more, and is, for example, 50 parts by mass or less, or preferably 30 parts by mass or less.

More preferably, the rubber composition contains a cross-linking auxiliary and a foaming auxiliary.

An example of the cross-linking auxiliary includes a cross-linking auxiliary that fails to contain a sulfur atom in a molecule. To be specific, examples thereof include a monohydric alcohol such as ethanol, a dihydric alcohol such as ethylene glycol, a trihydric alcohol such as glycerine, and a polyol (polyoxyalkylene glycol) such as polyethylene glycol and polypropylene glycol. The polyol has a number average molecular weight of, for example, 200 or more, preferably 300 or more, or more preferably 1000 or more, and of, for example, 100000 or less, preferably 10000 or less, or more preferably 5000 or less.

These cross-linking auxiliaries can be used alone or in combination of two or more.

As the cross-linking auxiliary, preferably, a polyol is used.

Among all, when the quinoid compound (the derivative of the p-quinonedioxime, in particular) is used as the cross-linking agent, as the cross-linking auxiliary, preferably, a polyol is used, more preferably a polyoxyalkylene glycol is used, or further more preferably, a polyethylene glycol is used.

By using the derivative of the p-quinonedioxime and the polyol in combination, the rubber composition is capable of being excellently cross-linked, so that excellent foaming properties and vibration resistance are capable of being ensured.

The mixing ratio of the cross-linking auxiliary with respect to 100 parts by mass of the EPDM is, for example, 0.01 parts by mass or more, preferably 0.02 parts by mass or more, or further more preferably 0.06 parts by mass or more, and is, for example, 20 parts by mass or less, preferably 10 parts by mass or less, more preferably 5 parts by mass or less, or further more preferably 2 parts by mass or less.

The mixing ratio of the cross-linking auxiliary with respect to 100 parts by mass of the cross-linking agent is, for example, 200 parts by mass or less, preferably 100 parts by mass or less, or more preferably 50 parts by mass or less, and is, for example, 1 part by mass or more, preferably 10 parts by mass or more, or more preferably 20 parts by mass or more. The mixing ratio of the cross-linking auxiliary with respect to 100 parts by mass of the quinoid compound, in particular, is, for example, 300 parts by mass or less, preferably 100 parts by mass or less, or more preferably 50 parts by mass or less, and is, for example, 1 part by mass or more, preferably 15 parts by mass or more, or more preferably 25 parts by mass or more.

Examples of the foaming auxiliary include a urea foaming auxiliary, a salicylic acid foaming auxiliary, a benzoic acid foaming auxiliary, and a metal oxide (for example, a zinc oxide and the like). Preferably, a urea foaming auxiliary and a metal oxide are used.

These foaming auxiliaries can be used alone or in combination of two or more. Preferably, a urea foaming auxiliary and a metal oxide are used in combination.

The mixing ratio of the foaming auxiliary with respect to 100 parts by mass of the EPDM is, for example, 0.5 parts by mass or more, preferably 1 part by mass or more, or more preferably 2 parts by mass or more, and is, for example, 20 parts by mass or less, preferably 15 parts by mass or less, or more preferably 10 parts by mass or less. When the urea foaming auxiliary and the metal oxide are used in combination, the mixing ratio of the urea foaming auxiliary with respect to 100 parts by mass of the metal oxide is, for example, 10 parts by mass or more, or preferably 20 parts by mass or more, and is, for example, 200 parts by mass or less, preferably 150 parts by mass or less, or more preferably 100 parts by mass or less.

The rubber composition can appropriately contain a processing auxiliary, a pigment, a flame retardant, a filler, a softener, a polymer other than the EPDM, or the like as required.

Examples of the processing auxiliary include a stearic acid and esters thereof and a zinc stearate. These processing auxiliaries can be used alone or in combination of two or more. The mixing ratio of the processing auxiliary with respect to 100 parts by mass of the EPDM is, for example, 0.1 parts by mass or more, or preferably 1 part by mass or more, and is, for example, 10 parts by mass or less, or preferably 5 parts by mass or less.

An example of the pigment includes carbon black. The pigment has an average particle size of, for example, 1 $\mu$m or more and 200 $\mu$m or less. The mixing ratio of the pigment with respect to 100 parts by mass of the EPDM is, for example, 1 part by mass or more, or preferably 2 parts by mass or more, and is, for example, 50 parts by mass or less, or preferably 30 parts by mass or less.

Examples of the flame retardant include calcium hydroxide, magnesium hydroxide, and aluminum hydroxide. The flame retardant has an average particle size of, for example, 0.1 $\mu$m or more and 100 $\mu$m or less. These flame retardants can be used alone or in combination of two or more. The mixing ratio of the flame retardant with respect to 100 parts by mass of the EPDM is, for example, 5 parts by mass or more, preferably 10 parts by mass or more, or further more preferably 15 parts by mass or more, and is, for example, 300 parts by mass or less, preferably 200 parts by mass or less, or more preferably 50 parts by mass or less.

Examples of the filler include an inorganic filler such as calcium carbonate, magnesium carbonate, silicic acid and salts thereof, clay, talc, mica powders, bentonite, silica, alumina, aluminum silicate, and aluminum powders; an organic filler such as cork; and other known fillers. These fillers can be used alone or in combination of two or more. The mixing ratio of the filler with respect to 100 parts by mass of the EPDM is, for example, 10 parts by mass or more, preferably 50 parts by mass or more, or more preferably 150 parts by mass or more, and is, for example, 300 parts by mass or less, or preferably 200 parts by mass or less.

Examples of the softener include petroleum oils (for example, paraffinic oil, naphthenic oil, drying oils, animal and vegetable oils (for example, linseed oil and the like), aromatic oil, and the like); asphalts; low molecular weight polymers; and organic acid esters (for example, phthalic ester (for example, di-2-ethylhexyl phthalate (DOP) and dibutyl phthalate (DBP)), phosphate ester, higher fatty acid ester, alkyl sulfonate ester, and the like). Preferably, petroleum oils are used, or more preferably, paraffinic oil is used. These softeners can be used alone or in combination of two or more. The mixing ratio of the softener with respect to 100 parts by mass of the EPDM is, for example, 5 parts by mass or more, or preferably 10 parts by mass or more, and is, for example, 100 parts by mass or less, or preferably 50 parts by mass or less.

Examples of the polymer other than the EPDM include a rubber-based polymer and a non-rubber-based polymer. Examples of the rubber-based polymer include a rubber-based copolymer (for example, $\alpha$-olefin (such as butene-1)-dicyclopentadiene, ethylidene norbornene, and the like) having a cyclic or acyclic polyene having non-conjugated double bonds as a component, an ethylene-propylene rubber, a silicone rubber, a fluororubber, an acrylic rubber, a polyurethane rubber, a polyamide rubber, a natural rubber, a polyisobutylene rubber, a polyisoprene rubber, a chloroprene rubber, a butyl rubber, a nitrile butyl rubber, a styrene-butadiene rubber, a styrene-butadiene-styrene rubber, a styrene-isoprene-styrene rubber, a styrene-ethylene-butadiene rubber, a styrene-ethylene-butylene-styrene rubber, a styrene-isoprene-propylene-styrene rubber, and a chlorosulfonated polyethylene rubber.

Examples of the non-rubber-based polymer include polyethylene, polypropylene, an acrylic polymer (for example, alkyl poly(meth)acrylate and the like), polyvinyl chloride, an ethylene-vinyl acetate copolymer, polyvinyl acetate, polyamide, polyester, chlorinated polyethylene, a urethane polymer, a styrene polymer, a silicone polymer, and an epoxy resin.

These polymers other than the EPDM can be used alone or in combination of two or more.

The mixing ratio of the polymer other than the EPDM with respect to 100 parts by mass of the EPDM is, for example, 100 parts by mass or less, or preferably 50 parts by mass or less.

Furthermore, the rubber composition can contain a known additive at an appropriate proportion as long as it does not damage the excellent effect of the vibration-proof material to be obtained in accordance with its purpose and use. Examples of the known additive include a plasticizer, a tackifier, an oxidation inhibitor, an antioxidant, a colorant, and a fungicide.

On the other hand, preferably, the rubber composition fails to contain a vulcanizing retardant containing a sulfur atom S (for example, thiazoles, thioureas, and the like).

When the rubber composition fails to contain a vulcanizing retardant, the content proportion of the sulfur atom S in the vibration-proof material is capable of being reduced and a reduction in the corrosive properties is capable of being achieved.

Next, a method for producing the vibration-proof material is described.

In order to produce (prepare) the vibration-proof material, first, the above-described components are blended to be kneaded using a kneader, a mixer, a mixing roller, or the like, so that the rubber composition is kneaded as a kneaded material (a kneading step).

In the kneading step, the components can be also kneaded, while being appropriately heated. Also, in the kneading step, for example, components other than a cross-linking agent, a cross-linking auxiliary, a foaming agent, and a foaming auxiliary are first kneaded to obtain a first kneaded material. Thereafter, a cross-linking agent, a cross-linking auxiliary, a foaming agent, and a foaming auxiliary are added to the first kneaded material to be kneaded, so that the rubber composition (a second kneaded material) can be obtained.

The obtained rubber composition (the kneaded material) is extruded into a sheet shape or the like using an extruder (a molding step) and the extruded rubber composition is heated to be foamed (a foaming step).

A heat condition is appropriately selected in accordance with a cross-linking starting temperature of the cross-linking agent to be blended, a foaming temperature of the foaming agent to be blended, or the like. The rubber composition is preheated using, for example, an oven with internal air circulation at, for example, 40°C or more, or preferably 60°C or more, and at, for example, 200°C or less, or preferably 160°C or less for, for example, 1 minute or more, or preferably 5 minutes or more, and for, for example, 60 minutes or less, or preferably 40 minutes or less. After the preheating, the rubber composition is heated at, for example, 450°C or less, preferably 350°C or less, or more preferably 250°C or less, and at, for example, 100°C or more, or preferably 120°C or more for, for example, 5 minutes or more, or preferably 15 minutes or more, and for, for example, 80 minutes or less, or preferably 50 minutes or less.

According to the method for producing the vibration-proof material, corrosion of a vibration-proof object is suppressed and the vibration-proof material capable of reducing the vibration of the vibration-proof object is capable of being easily and surely produced.

The obtained rubber composition is extruded into a sheet shape using an extruder, while being heated (a molding step) (that is, a rubber composition sheet is fabricated), and the rubber composition in a sheet shape (the rubber composition sheet) is capable of being continuously cross-linked and foamed (a foaming step).

According to this method, the vibration-proof material is capable of being produced with excellent production efficiency.

In this way, the rubber composition is foamed and cross-linked, so that the vibration-proof material in a sheet shape prepared from the EPDM foamed material is capable of being obtained.

The obtained vibration-proof material has a thickness of, for example, 0.1 mm or more, or preferably 1 mm or more, and of, for example, 50 mm or less, or preferably 45 mm or less.

The vibration-proof material has, for example, an open cell structure (an open cell ratio of 100 %) or a semi-open/semi-closed cell structure (an open cell ratio of, for example, above 0 %, or preferably 10 % or more, and of, for example, less than 100 %, or preferably 98 % or less). Preferably, the vibration-proof material has a semi-open/semi-closed cell structure.

When the vibration-proof material has a semi-open/semi-closed cell structure, the improvement of the flexibility is capable of being achieved.

The vibration-proof material has an average cell size of, for example, 50 $\mu$m or more, preferably 100 $\mu$m or more, or more preferably 200 $\mu$m or more, and of, for example, 1200 $\mu$m or less, preferably 1000 $\mu$m or less, or more preferably 800 $\mu$m or less.

The vibration-proof material has a volume expansion ratio (a density ratio before and after foaming) of, for example, two times or more, or preferably five times or more, and of usually 30 times or less.

The vibration-proof material has an apparent density (in conformity with JIS K 6767 (1999)) of, for example,

0.50 g/cm$^3$ or less, preferably 0.20 g/cm$^3$ or less, or more preferably 0.10 g/cm$^3$ or less, and of, for example, 0.01 g/cm$^3$ or more. When the apparent density of the vibration-proof material is within the above-described range, the vibration-proof material is capable of excellently sealing a gap between the vibration-proof objects.

The vibration-proof material has a 50 % compressive load value (in conformity with JIS K 6767 (1999)) of, for example, 0.1 N/cm$^2$ or more, or preferably 0.15 N/cm$^2$ or more, and of, for example, 10 N/cm$^2$ or less, preferably 5.0 N/cm$^2$ or less, more preferably 2.5 N/cm$^2$ or less, further more preferably 1.0 N/cm$^2$ or less, or particularly preferably 0.3 N/cm$^2$ or less.

When the 50 % compressive load value of the vibration-proof material is within the above-described range, the flexibility of the vibration-proof material is capable of being improved and thus, the fittability to a vibration-proof object and the followability to irregularities are capable of being excellent and the vibration of the vibration-proof object is capable of being further surely reduced.

The vibration-proof material has a tensile strength (the maximum load in a tensile test in conformity with JIS K 6767 (1999)) of, for example, 1.0 N/cm$^2$ or more, or preferably 2.0 N/cm$^2$ or more, and of, for example, 50 N/cm$^2$ or less, or preferably 30.0 N/cm$^2$ or less. When the tensile strength of the vibration-proof material is within the above-described range, the strength of the vibration-proof material is capable of being excellent.

The vibration-proof material has an elongation (in conformity with JIS K 6767 (1999)) of, for example, 10 % or more, or preferably 150 % or more, and of, for example, 1500 % or less, or preferably 1000 % or less. When the elongation of the vibration-proof material is within the above-described range, the strength of the vibration-proof material is capable of being excellent.

The content ratio of a sulfur atom in the vibration-proof material, based on mass, is, for example, 1000 ppm or less, preferably 800 ppm or less, more preferably 500 ppm or less, or further more preferably 200 ppm or less. When the content ratio of a sulfur atom S in the vibration-proof material is not more than the above-described upper limit, a reduction in the corrosive properties is capable of being achieved.

The content ratio of the sulfur atom S in the vibration-proof material is calculated based on a fluorescent X-ray measurement. The detailed conditions in the fluorescent X-ray measurement are described in detail in Examples later.

In the vibration-proof material, the content ratio of sulfur $S_8$ calculated based on the measurement result of a gel permeation chromatography is, for example, 100 ppm or less, preferably 50 ppm or less, or more preferably 25 ppm or less. When the content ratio of the sulfur $S_8$ in the vibration-proof material is not more than the above-described upper limit, a reduction in the corrosive properties is capable of being achieved.

A calculation method of the sulfur $S_8$ is described in detail in Examples later.

The vibration-proof material has a Young's modulus (at 23°C) of $6.0 \times 10^5$ Pa or less, preferably $3.0 \times 10^5$ Pa or less, more preferably $1.0 \times 10^5$ Pa or less, further more preferably $5.0 \times 10^4$ Pa or less, or particularly preferably $3.0 \times 10^4$ Pa or less, and, of, for example, $1.0 \times 10^3$ Pa or more, or preferably $5.0 \times 10^3$ Pa or more. When the Young's modulus is within the above-described range, the vibration of the vibration-proof object is capable of being sufficiently reduced and the vibration-proof material has excellent vibration resistance. A measurement method is described in detail in Examples later.

The vibration-proof material has a resonance magnification of, for example, 10 or less, or preferably 5 or less. A measurement method is described in detail in Examples later.

A region where the vibration-proof material has an amplitude magnification of 1.0 or less (that is, a region capable of reducing vibration) is at least, for example, 150 to 400 Hz, or preferably 100 to 400 Hz. A measurement method is described in detail in Examples later.

The vibration-proof material is used by being disposed at a surface of the vibration-proof object that serves as an object to be prevented from vibration. The vibration-proof material is capable of having both roles of a role of vibration proof and a role other than the vibration proof such as sound insulation, sound absorption, dust-proof, heat insulation, buffering, or water tight. That is, the vibration-proof material is also capable of being used as, for example, a sound insulation material, a sound absorbing material, a dust-proof material, a heat insulating material, a buffer material, or a water-stop material, each of which has vibration resistance.

In the vibration-proof material, the content ratio of the sulfur atom S calculated based on the fluorescent X-ray measurement is not more than a specific value, so that the corrosive properties are reduced and the Young's modulus is within a specific range, so that the vibration resistance is excellent. Thus, when the vibration-proof material is used, corrosion of the vibration-proof object is suppressed and the vibration of the vibration-proof object is capable of being reduced.

Examples of the vibration-proof object at which the vibration-proof material is provided include a disk drive such as a hard disk drive (HDD), a compact disk drive (CDD), and a digital video disk drive (DVDD); an engine; a motor; and inverter peripherals.

Next, one embodiment of a vibration-proof structure of the present invention is described.

The vibration-proof structure is provided with a vibration-proof material and a wired circuit board that is provided at a surface of the vibration-proof material.

In the wired circuit board, for example, a wired circuit board is provided at the surface (the upper surface) of the vibration-proof material. At this time, the wired circuit board may be directly disposed on the vibration-proof material. Alternatively, after a pressure-sensitive adhesive layer such as a double-coated pressure-sensitive adhesive tape is provided on the surface of the vibration-proof material, the wired circuit board may be disposed on the surface of the pressure-sensitive adhesive layer.

As the wired circuit board, a known or commercially available wired circuit board can be used.

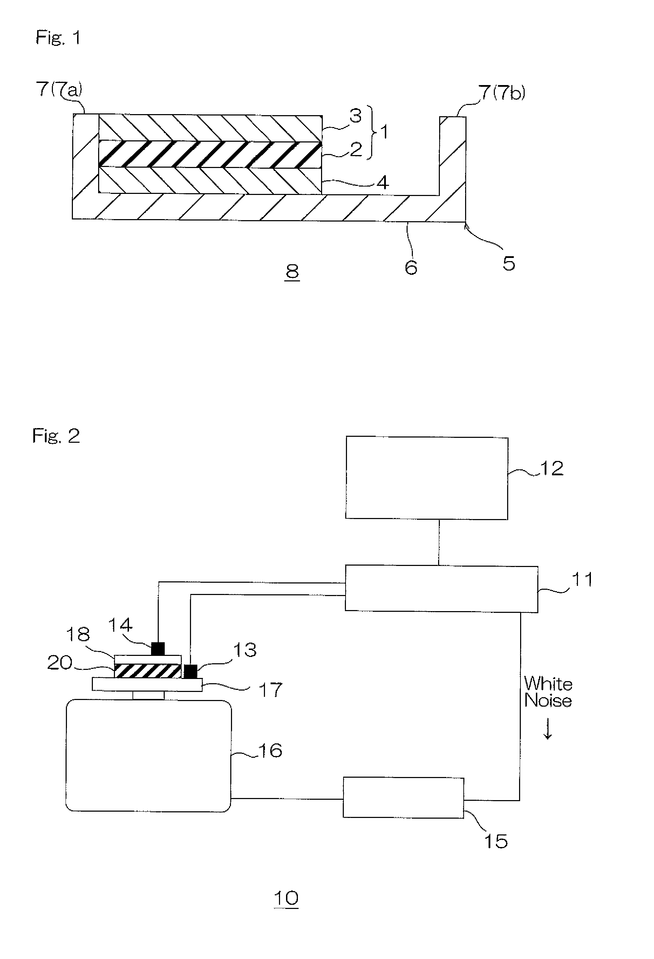

Next, one embodiment of an electrical and electronic device including the vibration-proof structure of the present invention is described with reference to FIG. 1.

The embodiment shown in FIG. 1 shows an electrical and electronic device 8 that is provided with a hard disk drive (HDD) 4. The electrical and electronic device 8 is provided with a casing 5 including a bottom wall 6 and side walls 7, the HDD 4 that is housed in the inside of the casing 5 and is disposed on the upper surface of the bottom wall 6, and a vibration-proof structure 1 that is disposed on the upper surface of the HDD 4 and includes a vibration-proof material 2 and a wired circuit board 3.

The casing 5 includes the bottom wall 6 in a generally flat plate shape and the side walls 7 (7a and 7b) that is disposed uprightly from the circumference end portion of the bottom wall 6.

The HDD 4 is, for example, formed into a generally rectangular shape in sectional view. The HDD 4 is housed in the inside of the casing 5. The lower surface of the HDD 4 is in contact with the upper surface of the bottom wall 6. The HDD 4 is disposed to be included in the bottom wall 6, when projected in the thickness direction. In the HDD 4, one end portion (the left end portion) in the plane direction (the right-left direction) thereof is disposed to be in contact with one side wall 7a and the other end portion (the right end portion) thereof is disposed apart from the other side wall 7b.

The vibration-proof structure 1 includes the vibration-proof material 2 and the wired circuit board 3 that is provided on the upper surface of the vibration-proof material 2.

In the vibration-proof material 2, the lower surface thereof is disposed in opposed relation to the upper surface of the HDD 4 so as to be in contact therewith. The vibration-proof material 2 is disposed to be overlapped with the HDD 4, when projected in the thickness direction. That is, in the vibration-proof material 2, one end portion in the plane direction thereof is disposed to be in contact with the one side wall 7a and the other end portion thereof is disposed apart from the other side wall 7b.

The wired circuit board 3 is a board to be configured to send instructions such as reading and writing to the HDD 4 and is formed into a flat plate shape. In the wired circuit board 3, the lower surface thereof is disposed to be in contact with the upper surface of the vibration-proof material 2. The wired circuit board 3 is disposed to be overlapped with the vibration-proof material 2, when projected in the thickness direction. That is, in the wired circuit board 3, one end portion in the plane direction thereof is disposed to be in contact with the one side wall 7a and the other end portion thereof is disposed apart from the other side wall 7b.

According to the electrical and electronic device 8 including the vibration-proof structure 1, the vibration-proof material 2 is interposed between the HDD 4 and the wired circuit board 3. Thus, in the electrical and electronic device 8, even when a vibration or impact is applied to the casing 5, the vibration or impact with respect to the wired circuit board 3 is suppressed and the instructions from the wired circuit board 3 to the HDD 4 are capable of being accurately sent. Also, the content proportion of the sulfur atom in the vibration-proof material 2 is not more than a specific value, so that corrosion of the wired circuit board 3 and the HDD 4 is capable of being sufficiently suppressed.

Examples

While the present invention will be described hereinafter in further detail with reference to Examples and Comparative Examples, the present invention is not limited to these Examples and Comparative Examples. Values in Examples shown in the following can be replaced with the values (that is, the upper limit value or the lower limit value) described in the above-described embodiment.

Examples 1 to 7 and Comparative Examples 1 to 3

(1) Production of Vibration-Proof Material

A polymer, a processing auxiliary, a pigment, a flame retardant, a filler, and a softener were blended at a mixing amount described in the mixing formulation shown in Table 1 to be kneaded with a 3L pressurizing kneader, so that a first kneaded material was prepared.

Separately, a cross-linking agent, a cross-linking auxiliary, a foaming agent, and a foaming auxiliary (in the case of Comparative Examples 1 to 3, a vulcanizing retardant) were blended. Thereafter, the obtained mixture was blended into the first kneaded material to be kneaded with a 10-inch mixing roll to prepare a rubber composition (a second kneaded material) (a kneading step).

Next, the rubber composition was extruded into a sheet shape having a thickness of about 8 mm using a single screw extruder (45 mm$\phi$), so that a rubber composition sheet was fabricated (a molding step).

Subsequently, the rubber composition sheet was preheated at 140°C for 20 minutes with an oven with internal air circulation. Thereafter, the temperature of the oven with internal air circulation was increased to 170°C over 10 minutes, so that the rubber composition sheet was heated at 170°C for 10 minutes to be foamed (a foaming step) and in this way, a vibration-proof material prepared from an EPDM foamed material was produced.

(2) Measurement of Properties

The properties of each of the vibration-proof materials in Examples 1 to 7 and Comparative Examples 1 to 3 were measured by a method shown in the following. The results are shown in Table 1.

<Apparent Density>

The apparent density of each of the vibration-proof materials was measured in conformity with JIS K 6767 (1999). To be specific, a skin layer of each of the vibration-proof materials was removed and a test piece having a thickness of about 10 mm was prepared. Thereafter, the mass was measured to calculate the mass per unit volume (the apparent density).

<50 % Compressive Load Value>

The 50 % compressive load value of each of the vibration-proof materials was measured in conformity with JIS K 6767 (1999). To be specific, a skin layer of each of the vibration-proof materials was removed and a test piece having a thickness of about 10 mm was prepared. Thereafter, the test piece was compressed by 50 % at a compression rate of 10 mm/min using a compression testing machine to measure a 50 % compressive load value after 10 seconds of compression.

<Tensile Strength and Elongation>

The tensile strength and the elongation of each of the vibration-proof materials were measured in conformity with JIS K 6767 (1999). To be specific, a skin layer of each of the vibration-proof materials was removed and a test piece having a thickness of about 10 mm was prepared. Thereafter, the test piece was stamped out using a dumbbell No. 1 to obtain a sample for measurement. The sample for measurement was pulled with a tensile testing machine at a tension rate of 500 mm/min to measure the load (the tensile strength) and the elongation of the sample for measurement at the time of being cut in a dumbbell shaped parallel portion.

<Content Proportion of Sulfur Atom S (Fluorescent X-Ray Measurement)>

Each of the vibration-proof materials was cut into pieces each having an appropriate size. Four pieces thereof were stacked and were subjected to a fluorescent X-ray measurement (XRF) (measurement size: 30 mm$\phi$). A device and conditions for the XRF are shown in the following.

    XRF device: manufactured by Rigaku Corporation, ZXS 100e
    X-ray source: vertical Rh tube
    Analysis area: 30 mm$\phi$
    Analysis range of elements: B to U

In addition, the quantification was calculated from the proportion of the total atoms that were detected.

<Content Proportion of Sulfur $S_8$ (GPC Measurement)>

In each of the vibration-proof materials, the content proportion of sulfur $S_8$ was calculated based on the measurement result of a gel permeation chromatography (GPC). A process, conditions, a device, and the like are shown in the following.

(Process 1)

Each of the vibration-proof materials was finely cut to fabricate test pieces each having an average value of the maximum length of 5 mm. Next, 300 mg of the vibration-proof material was weighed and then, 10 ml of THF (tetrahydrofuran) was added thereto using a whole pipette to be allowed to stand overnight.

A THF solution was filtrated with a 0.45 $\mu$m membrane filter and the filtrate was subjected to a gel permeation chromatography measurement.

(Process 2)

Separately, the sulfur $S_8$ was dissolved into the THF to adjust the concentration to 1000 $\mu$g/ml and the THF solution was allowed to stand overnight. Thereafter, the THF solution was filtrated with the 0.45 $\mu$m membrane filter.

The filtrate was diluted at predetermined concentrations to fabricate reference solutions. The reference solutions were subjected to the gel permeation chromatography measurement and the calibration curve was drawn from each of the peak area values to be obtained.

(Process 3)

The mass of the sulfur $S_8$ in the test piece in the Process 1 was obtained by a calibration curve method based on the calibration curve drawn in the Process 2. The obtained value was divided by the mass (300 mg) of the test piece, so that the content proportion of the sulfur $S_8$ in the test piece was calculated.

<Measurement Device and Measurement Conditions>

GPC device: TOSOH HLC-8120 GPC
Column: TSKgel Super HZ2000/HZ2000/HZ1000/HZ1000
Column size: 6.0 mmI.D.×150 mm
Elute: THF
Flow rate: 0.6 ml/min
Detector: UV (280 nm)
Column temperature: 40°C
Injection amount: 20 $\mu$l
Detection limit: 10 ppm

<Measurement of Young's Modulus and Vibration Resistance>

First, each of the vibration-proof materials was cut into pieces each having a predetermined shape (a length of 50 mm, a width of 50 mm, and a thickness of 10 mm) to obtain samples for measurement for the Young's modulus and the vibration resistance.

The amplitude magnification for each of the frequencies of the vibration-proof material was measured by an impedance method, to be specific, using a measurement device shown in FIG. 2. That is, a measurement device 10 is provided with an FFT analyzer 11, a control device 12 that is connected to the FFT analyzer 11 and stores an analyzing software, a first acceleration sensor 13 and a second acceleration sensor 14, each of which is connected to the FFT analyzer 11, an amplifier 15 that is connected to the FFT analyzer 11, a vibration exciter 16 that is connected to the amplifier 15, and a disk-shaped support 17 (a diameter of 100 mm, a thickness of 4 mm, and a mass of 89.2 g) that is fixed to the upper portion of the vibration exciter 16.

Next, a sample for measurement 20 was disposed at a generally central portion of the disk-shaped support 17 and a weight (a rectangular shape, 50 mm × 50 mm, a thickness of 5 mm, a mass of 100 g, a material of SUS) 18 was disposed on the upper surface of the sample for measurement 20. Thereafter, the second acceleration sensor 14 was fixed to the central portion of the upper surface of the weight 18. On the other hand, the first acceleration sensor 13 was fixed to the upper surface of the disk-shaped support 17 apart from the sample for measurement 20 in the plane direction (the right-left direction).

Next, a white noise (0 to 400 Hz) was output from the FFT analyzer 11 toward the amplifier 15 and the disk-shaped support 17 was vibrated via the vibration exciter 16.

At this time, the vibration generated by the first acceleration sensor 13 and the second acceleration sensor 14 was detected with the FFT analyzer 11. The detection signals were analyzed by the analyzing software stored in the control device 12 to calculate a frequency region having a resonance frequency fo, a resonance magnification (the maximum amplitude ratio in a frequency region to be measured), and an amplitude magnification of 1.0 or less. The frequency region having an amplitude magnification of 1.0 or less is a frequency region where the vibration is reduced.

Thus, the wider range of the frequency region (that is, the frequency region having a lower frequency region where the amplitude magnification begins to be 1.0 or less) is preferable as a vibration-proof material.

A Young's modulus E (Pa) was obtained from the following formula.

[Formula 1]

$$E = \frac{f_0{}^2 \times 4\pi^2 \times M \times H}{A}$$

Codes in formula are shown in the following.

fo: resonance frequency (Hz)
M: total mass of sample for measurement and weight (kg)
H: thickness of sample for measurement (m)
A: area in contact with disk-shaped support in sample for measurement (m$^2$)

The measurement was performed using the following measurement device under the following measurement conditions.

FFT analyzer: "Type 3160-A-022" (trade name), manufactured by Spectris Co., Ltd.
Analyzing software: PULSE Labshop ver. 16.10
Vibration exciter: "Type 4809", manufactured by Spectris Co., Ltd.
Amplifier: "Type 2706", manufactured by Spectris Co., Ltd.
Measurement temperature: 23°C

<Corrosive Properties of Silver>

0.5 g of each of the vibration-proof materials was put into a 100-mL sealed bottle. A polished and cleansed silver plate was attached to the inner side of a lid of the sealed bottle. The resulting bottle was put into a thermostatic chamber at 85°C for seven days and a presence or absence of corrosion of the silver plate was checked. When the corrosion was not confirmed, the result was evaluated as "Absence". When the corrosion was confirmed, the result was evaluated as "Presence".

The results are shown in Table 1.

[Table 1]

Table 1

| | | Ex. 1 | Ex. 2 | Ex. 3 | Ex. 4 | Ex. 5 | Ex. 6 | Ex. 7 | Comp. Ex. 1 | Comp. Ex. 2 | Comp. Ex. 3 |
|---|---|---|---|---|---|---|---|---|---|---|---|
| Polymer | EPDM (A) | 100 | 100 | 100 | 100 | 100 | 100 | 100 | | | |
| | EPDM (B) | | | | | | | | | 50 | |
| | EPDM (C) | | | | | | | | | 50 | |
| | EPDM (D) | | | | | | | | 100 | | 100 |
| Processing Auxiliary | Stearic Acid | 3 | 3 | 3 | 3 | 3 | 3 | 3 | 3 | 3 | 3 |
| Pigment | Carbon Black | 10 | 10 | 10 | 10 | 10 | 10 | 10 | 10 | 10 | 10 |
| Flame Retardant | Aluminum Hydroxide | 15 | 15 | 100 | | 100 | 50 | 50 | 30 | | |
| | Magnesium Hydroxide | 15 | 15 | 100 | 200 | 150 | 150 | 150 | | | |
| Filler | Calcium Carbonate | 150 | 150 | 100 | 100 | 50 | 100 | 100 | 150 | 100 | 200 |
| Softener | Paraffinic Oil | 30 | 30 | 30 | 30 | 30 | 30 | 30 | 35 | 40 | 35 |
| | Polyethylene Wax | | | | | | | 3 | | | |
| | Paraffin Wax | | | | | | | | | 5 | |
| | Blown Asphalt | | | | | | | | | 150 | |
| Cross-Linking Agent | p-quinonedioxime | | | | | | | | | | 0.4 |
| | p,p'-dibenzoylquinonedioxime | 2.8 | 2.8 | 1 | 1 | 1 | 1 | 1 | | | |
| | $\alpha,\alpha'$-di(t-butylperoxy)diisopropyl benzene | 1 | 1 | 1 | 1 | 1 | 1 | 1 | | | |
| | Sulfur | | | | | | | | 3 | 3 | |
| Cross-Linking Auxiliary | Polyethylene Glycol | 0.8 | 0.6 | 3 | 3 | 3 | 3 | 3 | | | |
| Foaming Agent | ADCA | 20 | 20 | 30 | 30 | 30 | 30 | 30 | 20 | 15 | 20 |
| Foaming Auxiliary | Zinc Oxide | 5 | 5 | 5 | 5 | 5 | 5 | 5 | 5 | 5 | 5 |
| | Urea Foaming Auxiliary | 2 | 2 | 7.5 | 7.5 | 7.5 | 7.5 | 7.5 | 2 | 3 | 5 |

EP 2 805 991 A1

| | | Ex. 1 | Ex. 2 | Ex. 3 | Ex. 4 | Ex. 5 | Ex. 6 | Ex. 7 | Comp. Ex. 1 | Comp. Ex. 2 | Comp. Ex. 3 |
|---|---|---|---|---|---|---|---|---|---|---|---|
| Vulcanizing Retardant | 2-Mercaptobenzothiazole | | | | | | | | 1 | 0.5 | |
| | Zinc Dibenzyldithiocarbamate | | | | | | | | | 0.5 | |
| | Tetrabenzylthiuram Disulfide | | | | | | | | | 0.5 | |
| | N,N'-dibutylthiourea | | | | | | | | 1.5 | 12 | 1 |
| | Zinc Dimethyldithiocarbamate | | | | | | | | | 1 | |
| | Zinc Diethyldithiocarbamate | | | | | | | | | 1 | |
| Apparent Density (g/cm$^3$) | | 0.096 | 0.110 | 0.114 | 0.077 | 0.095 | 0.083 | 0.085 | 0.090 | 0.100 | 0.085 |
| 50 % Compressive Load Value (N/cm$^2$) | | 0.18 | 028 | 0.42 | 122 | 029 | 024 | 0.33 | 0.40 | 0.42 | 634 |
| Tensile Strength (N/cm$^2$) | | 5.89 | 5.88 | 6.12 | 6.08 | 6.51 | 6.9 | 6.92 | 6.5 | 8.85 | 7.04 |
| Elongation (%) | | 288 | 325 | 155 | 148 | 163 | 193 | 180 | 290 | 540 | 265 |
| Sulfur Atom Content (ppm) XRF | | 180 | 210 | 130 | 150 | 150 | 120 | 140 | 7700 | 9800 | 450 |
| Sulfur $S_8$ Content (ppm) GPC | | 10 or less | 10 or less | 10 or less | 10 or less | 10 or less | 10 or less | 10 or less | 2800 | 650 | 10 or less |
| Young's Modulus (Pa) | | $2.10 \times 10^4$ | $4.60 \times 10^4$ | $1.44 \times 10^5$ | $125 \times 10^5$ | $125 \times 10^5$ | $7.56 \times 10^4$ | $1.06 \times 10^5$ | $3.95 \times 10^4$ | $1.99 \times 10^5$ | $6.58 \times 10^5$ |
| Resonance Frequency (Hz) | | 36.0 | 50.0 | 94.0 | 88.0 | 88.0 | 68.5 | 81.0 | 49.5 | 111.0 | 202.0 |
| Resonance Magnification | | 2.71 | 3.44 | 2.50 | 330 | 3.42 | 3.88 | 3.67 | 5.09 | 3.07 | 2.62 |
| Amplitude Magnification 1.0 or less | | 64 Hz or more | 94 Hz or more | 147 Hz or more | 158 Hz or more | 135 Hz or more | 125 Hz or more | 138 Hz or more | 76 Hz or more | 184 Hz or more | 350 Hz or more |
| Corrosive Properties of Silver | | Absence | Absence | Absence | Absence | Absence | Absence | Absence | Presence | Presence | Absence |

EP 2 805 991 A1

Values in Table 1 show the number of blended parts by mass in each of the components.

For the abbreviations shown in Table 1, the details are given in the following.

EPDM (A): EPT 8030M, containing long chain branching, a diene (5-ethylidene-2-norbornene) content of 9.5 mass %, catalyst: a metallocene catalyst, manufactured by Mitsui Chemicals, Inc.

EPDM (B): EPT 3045, a diene (5-ethylidene-2-norbornene) content of 4.7 mass %, catalyst: a Ziegler-Natta catalyst, manufactured by Mitsui Chemicals, Inc.

EPDM (C): EP-24, a diene (5-ethylidene-2-norbornene) content of 4.5 mass %, catalyst: a Ziegler-Natta catalyst, manufactured by Mitsui Chemicals, Inc.

EPDM (D): Eptalloy PX-047, a diene (5-ethylidene-2-norbornene) content of 4.5 mass %, polyethylene blend type, a polyethylene content of 20 PHR, catalyst: a Ziegler-Natta catalyst, manufactured by Mitsui Chemicals, Inc.

Stearic Acid: stearic acid powder "Sakura", manufactured by NOF CORPORATION

Carbon Black: Asahi #50, an average particle size of 80 $\mu$m, manufactured by ASAHI CARBON CO., LTD.

Aluminum Hydroxide: HIGILITE H-42, an average particle size of 1 to 2 $\mu$m, manufactured by SHOWA DENKO K.K.

Magnesium Hydroxide: KISUMA 5A, an average particle size of 1 $\mu$m, manufactured by Kyowa Chemical Industry Co., Ltd.

Calcium Carbonate: N heavy calcium carbonate, manufactured by MARUO CALCIUM CO., LTD.

Paraffinic Oil: Diana Process Oil PW-380, manufactured by Idemitsu Kosan Co., Ltd.

Polyethylene Wax: HI-WAX 110P, manufactured by Mitsui Chemicals, Inc.

Paraffin Wax: Prapellet 130, manufactured by Taniguchi Petroleum Co., Ltd.

Blown Asphalt: Trumbull Base Asphalt 4402, manufactured by Owens Coming Sales LLC Trumbull

p-quinonedioxime: VULNOC GM, manufactured by OUCHI SHINKO CHEMICAL INDUSTRIAL CO., LTD.

p,p'-dibenzoylquinonedioxime: VULNOC DGM, manufactured by OUCHI SHINKO CHEMICAL INDUSTRIAL CO., LTD.

$\alpha,\alpha'$-di(t-butylperoxy)diisopropyl benzene: PERBUTYL P-40MB (K), manufactured by NOF CORPORATION

Sulfur $S_8$: ALPHAGRAN S-50EN, manufactured by Touchi Co., Ltd.

Polyethylene Glycol: PEG 4000S, a number average molecular weight of 3400

ADCA: AC#LQ, Azodicarbonamide, manufactured by EIWA CHEMICAL IND. CO., LTD.

Zinc Oxide: second-class zinc oxide, manufactured by MITSUI MINING & SMELTING CO., LTD.

Urea Foaming Auxiliary: CELLPASTE K5, manufactured by EIWA CHEMICAL IND. CO., LTD.

2-Mercaptobenzothiazole: NOCCELER M, manufactured by OUCHI SHINKO CHEMICAL INDUSTRIAL CO., LTD.

Zinc Dibenzyldithiocarbamate; NOCCELER ZTC, manufactured by OUCHI SHINKO CHEMICAL INDUSTRIAL CO., LTD.

Tetrabenzylthiuram Disulfide: NOCCELER TBzTD, manufactured by OUCHI SHINKO CHEMICAL INDUSTRIAL CO., LTD.

N,N'-dibutylthiourea: NOCCELER BUR, manufactured by OUCHI SHINKO CHEMICAL INDUSTRIAL CO., LTD.

Zinc Dimethyldithiocarbamate: NOCCELER PZ, manufactured by OUCHI SHINKO CHEMICAL INDUSTRIAL CO., LTD.

Zinc Diethyldithiocarbamate: NOCCELER EZ, manufactured by OUCHI SHINKO CHEMICAL INDUSTRIAL CO., LTD.

**Claims**

1.  A vibration-proof material obtained by foaming a rubber composition containing an ethylene-propylene-diene rubber, wherein
    the content ratio of a sulfur atom calculated based on the measurement result of a fluorescent X-ray measurement, based on mass, is 1000 ppm or less and
    the vibration-proof material has a Young's modulus at 23°C of $6.0 \times 10^5$ Pa or less.

2.  The vibration-proof material according to claim 1, wherein
    the content ratio of sulfur $S_8$ calculated based on the measurement result of a gel permeation chromatography, based on mass, is 100 ppm or less.

3.  The vibration-proof material according to claim 1, wherein
    the vibration-proof material has an apparent density of 0.20 g/cm$^3$ or less.

4.  The vibration-proof material according to claim 1, wherein

the rubber composition contains a derivative of p-quinonedioxime and a polyol.

5. The vibration-proof material according to claim 4, wherein
the polyol is a polyethylene glycol.

6. The vibration-proof material according to claim 1, wherein
the rubber composition further contains an organic peroxide.

7. The vibration-proof material according to claim 1, wherein
the ethylene-propylene-diene rubber has long chain branching.

8. A vibration-proof structure comprising:

a vibration-proof material obtained by foaming a rubber composition containing an ethylene-propylene-diene rubber, wherein
the content ratio of a sulfur atom calculated based on the measurement result of a fluorescent X-ray measurement, based on mass, is 1000 ppm or less and
the vibration-proof material has a Young's modulus at 23°C of $6.0 \times 10^5$ Pa or less and
a wired circuit board provided at a surface of the vibration-proof material.

9. A vibration-proof method comprising the steps of:

preparing a vibration-proof material obtained by foaming a rubber composition containing an ethylene-propylene-diene rubber, wherein
the content ratio of a sulfur atom calculated based on the measurement result of a fluorescent X-ray measurement, based on mass, is 1000 ppm or less and
the vibration-proof material has a Young's modulus at 23°C of $6.0 \times 10^5$ Pa or less and
providing the vibration-proof material in a wired circuit board.

Fig. 1

Fig. 2

10

Europäisches
Patentamt

European
Patent Office

Office européen
des brevets

## EUROPEAN SEARCH REPORT

Application Number

EP 14 15 9322

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 1 964 864 A1 (NITTO DENKO CORP [JP]) 3 September 2008 (2008-09-03) * paragraphs [0001], [0014] - [0029], [0040] - [0051] * * paragraphs [0053] - [0063]; examples 1-9; table 1 * | 1-9 | INV. C08J9/00 C08J9/10 F16F15/00 F16F1/36 |
| X | JP 2000 159953 A (SUMITOMO CHEMICAL CO) 13 June 2000 (2000-06-13) * paragraphs [0001], [0003] - [0028], [0035] - [0037]; examples 1-3 * | 1-3,6-9 | |
| X,P | WO 2013/042657 A1 (NITTO DENKO CORP [JP]) 28 March 2013 (2013-03-28) * paragraphs [0132] - [0163]; examples 1-6; tables 1-2 * * claims 1-10 * | 1-7 | |
| X,P | WO 2013/042656 A1 (NITTO DENKO CORP [JP]) 28 March 2013 (2013-03-28) * paragraphs [0125] - [0157]; examples 1, 2, 5-8; tables 1-2 * * claims 1-10 * | 1-7 | TECHNICAL FIELDS SEARCHED (IPC) |
| X,P | WO 2013/042649 A1 (NITTO DENKO CORP [JP]) 28 March 2013 (2013-03-28) * paragraphs [0139] - [0154]; examples 4, 9; tables 1-4 * * claims 1-10 * | 1-7 | C08J F16F H05K |
| X,P | WO 2013/042650 A1 (NITTO DENKO CORP [JP]) 28 March 2013 (2013-03-28) * paragraphs [0138] - [0152]; examples 1, 8, 9; tables 1-4 * * claims 1-12 * | 1-7 | |

The present search report has been drawn up for all claims

| Place of search | Date of completion of the search | Examiner |
|---|---|---|
| The Hague | 16 October 2014 | Mayer, Anne |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 14 15 9322

This annex lists the patent family members relating to the patent documents cited in the above-mentioned European search report.
The members are as contained in the European Patent Office EDP file on
The European Patent Office is in no way liable for these particulars which are merely given for the purpose of information.

16-10-2014

| Patent document cited in search report | | Publication date | Patent family member(s) | | Publication date |
|---|---|---|---|---|---|
| EP 1964864 | A1 | 03-09-2008 | AT | 451401 T | 15-12-2009 |
| | | | CN | 101255257 A | 03-09-2008 |
| | | | EP | 1964864 A1 | 03-09-2008 |
| | | | JP | 4993470 B2 | 08-08-2012 |
| | | | JP | 2008208256 A | 11-09-2008 |
| | | | US | 2008207786 A1 | 28-08-2008 |
| JP 2000159953 | A | 13-06-2000 | NONE | | |
| WO 2013042657 | A1 | 28-03-2013 | CN | 103827181 A | 28-05-2014 |
| | | | EP | 2759567 A1 | 30-07-2014 |
| | | | US | 2014234610 A1 | 21-08-2014 |
| | | | WO | 2013042657 A1 | 28-03-2013 |
| WO 2013042656 | A1 | 28-03-2013 | CN | 103827183 A | 28-05-2014 |
| | | | EP | 2759564 A1 | 30-07-2014 |
| | | | US | 2014238775 A1 | 28-08-2014 |
| | | | WO | 2013042656 A1 | 28-03-2013 |
| WO 2013042649 | A1 | 28-03-2013 | CN | 103814069 A | 21-05-2014 |
| | | | EP | 2759568 A1 | 30-07-2014 |
| | | | JP | 2013079366 A | 02-05-2013 |
| | | | US | 2014220334 A1 | 07-08-2014 |
| | | | WO | 2013042649 A1 | 28-03-2013 |
| WO 2013042650 | A1 | 28-03-2013 | CN | 103827182 A | 28-05-2014 |
| | | | EP | 2759565 A1 | 30-07-2014 |
| | | | JP | 2013079364 A | 02-05-2013 |
| | | | US | 2014234611 A1 | 21-08-2014 |
| | | | WO | 2013042650 A1 | 28-03-2013 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000065134 A